# EUROPEAN PATENT APPLICATION

(11) **EP 0 694 968 A2**
(43) Date of publication of application: **31.01.1996**
(21) Application number: 95111789.4
(22) Date of filing: 26.07.1995
(51) Int. Cl.: H01L 25/065, H01L 23/36

(54) **Multi-chip module semiconductor device**

(30) Priority: 26.07.1994 JP 193757/94
(71) Applicant: NEC CORPORATION, Tokyo (JP)
(72) Inventor: Koike, Tsuneo, c/o NEC Corporation, Tokyo (JP)
(74) Representative: Glawe, Delfs, Moll & Partner

(57) **Abstract**

A multi-chip module semiconductor device comprises a base board, at least one first semiconductor device chip mounted on a first surface of the base board, at least one second semiconductor device chip mounted on a second surface of the base board, a first heat dissipating member provided for only the at least one first semiconductor device chip, and a second heat dissipating member provided for only the at least one second semiconductor device chip, independently of the first heat dissipating member. Further, the at least one first semiconductor device chip is preferably mounted through a first thermally insulating structure on the first surface of the base board, and the at least one second semiconductor device chip is preferably mounted through a second thermally insulating structure on the second surface of the base board. Thus, heat generated by the chip mounted through on one surface of the base board, will never influence the chip mounted through on the other surface of the base board. Therefore, the chips can be mounted on opposite surfaces of the base board without the problem of the heat and with an elevated integrated density.

## Description

### Background of the Invention

### Field of the invention

The present invention relates to a semiconductor device, and more specifically to a semiconductor device of a multi-chip module type in which a plurality of semiconductor device chips are mounted on a single wiring board.

### Description of related art

Recently, in a field in which a high speed operation is expected by reducing a wiring delay between semiconductor devices, and with a demand of increasing an integration density of the semiconductor devices by miniaturizing and making the semiconductor devices lightweight, attention has been attracted to a so called "multi-chip module" in which a plurality of semiconductor device chips are mounted on a single wiring board. In this specification, the semiconductor device chip will be often called a "chip" simply.

Japanese Patent Application Laid-open Publication JP-A-5-136323 shows one example of this multi-chip module. Referring to Figure 1, there is shown a diagrammatic sectional view of one example shown in JP-A-5-136323. As shown in Figure 1, this conventional example includes one base board 301 and a plurality of semiconductor device chips 302 mounted on opposite surfaces of the base board 301, respectively. Lead frames 303 are electrically connected to each of the chips 302 through bonding wires 304, and the assembly thus obtained is encapsulated with resin for protection from external environment, so that a package 305 is formed.

Thus, since two chips can be mounted in the same area, the integration density can be increased to a double.

However, an operation of the semiconductor device chip depends upon a junction temperature. For example, in the case of CMOS transistors, it has been known that if the junction temperature elevates, the switching speed drops. Therefore, in an ordinary semiconductor device, the junction temperature is limited in order to ensure the operation speed of the semiconductor device, and therefore, the use temperature of the semiconductor device is limited.

In the conventional multi-chip module as mentioned above, however, if heat generated from one chip mounted on one surface of the base board is transferred through the base board to the other chip mounted on the other surface of the base board, the junction temperature of the other chip elevates, so that it becomes impossible to guarantee the operation speed of the other chip in an extreme case. Alternatively, it becomes impossible to guarantee the operation itself of the chip. For example, in the conventional multi-chip module assembled with a microprocessor and a cache memory, the microprocessor ordinarily consumes a large electric power, and correspondingly, the amount of generated heat is large. On the other hand, since the cache memory is required to operate at a high speed, the cache memory is formed of a static memory. The generated heat amount of the static memory is smaller than that of the microprocessor, but the operation speed of the static memory lowers with elevation of the junction temperature caused by the heat generated by the microprocessor. As a result, the static memory often becomes not to function as the cache memory, so that the multi-chip module cannot operate properly.

In order to avoid the above mentioned problem of the multi-chip module, Japanese Patent Application Laid-open Publication JP-A-59-65457 has shown one heat dissipating structure of the multi-chip module. Referring to Figure 2, there is shown a diagrammatic sectional view of one example shown in JP-A-59-65457. As shown in Figure 2, this conventional example includes a plurality of semiconductor device chips 402 mounted by means of a plurality of bumps 403 on an upper surface of a wiring base board 401 having a number of connection pins 406 extending from its lower surface, and a heat sink 405 is bonded to the upper surface of the chips 402 by use of a bonding agent 404, so that the chips 402 are thermally coupled to the heat sink 405. In this structure, heat generated by each chip 402 is transferred through the bonding agent 404 to the heat sink 405 and also dissipated into air from the heat sink 405.

Japanese Patent Application Laid-open Publication JP-A-61-47653 has shown another heat dissipating structure of the multi-chip module in which, for the purpose of heat dissipation, a plurality of chips are directly contacted to a cap for encapsulating the chips within the multi-chip module. Referring to Figure 3, there is shown a diagrammatic sectional view of one example shown in JP-A-61-47653. As shown in Figure 3, this conventional example includes a plurality of semiconductor device chips 502 mounted by means of a plurality of bumps 503 on one surface of a wiring base board 501, and a cap 504 in the form of a predetermined shape mounted on the base board 501 to cover the chips 502 in such a manner that an upper surface of the chips 402 is in direct contact with the cap 504 so that heat generated by the chips are dissipated through the cap 504.

In the heat sink type heat dissipating structure of the multi-chip module disclosed in JP-A-59-65457, however, if there is used a heat sink having a sufficient heat dissipating effect to maintain the temperature of the whole of the multi-chip module within a permissible range of the junction temperature, the heat dissipating structure becomes large in size, and therefore, the multi-chip module correspondingly becomes large in size. In addition, since the chips have to be mounted on the wiring base board to oppose to the heat sink, it is not possible to mount the chips on opposite surfaces of the wiring base board. Therefore, it is difficult to increase the integrated density of the multi-chip module.

On the other hand, the cap type heat dissipating structure of the multi-chip module disclosed in JP-A-61-47653 can realize a more efficient heat dissipation than that disclosed in JP-A-59-65457, since there is no bonding agent between the chips and the heat dissipating member. However, in order to make the thermal resistance sufficiently small, a close contact between the chips and the cap is very important, and therefore, the cap preformed in a special shape is required, with the result that the assembling becomes difficult. In addition, since the chips are mounted to oppose to the cap, it is difficult to increase the integrated density of the multi-chip module by mounting the chips on opposite surfaces of the wiring base board.

### Summary of the Invention

Accordingly, it is an object of the present invention to provide a multi-chip module semiconductor device which has overcome the above mentioned defect of the conventional ones.

Another object of the present invention is to provide a multi-chip module semiconductor device having a high heat dissipating effect without increasing the size of the multi-chip module, so that the integrated density of the multi-chip module can be increased.

The above and other objects of the present invention are achieved in accordance with the present invention by a multi-chip module semiconductor device comprising a base board, at least one first semiconductor device chip mounted on a first surface of the base board, at least one second semiconductor device chip mounted on a second surface of the base board, a first heat dissipating member provided for only the at least one first semiconductor device chip, and a second heat dissipating member provided for only the at least one second semiconductor device chip, independently of the first heat dissipating member.

According to another aspect of the present invention, there is provided a multi-chip module semiconductor device comprising a base board, at least one first semiconductor device chip mounted through a first thermally insulating structure on a first surface of the base board, and at least one second semiconductor device chip mounted through a second thermally insulating structure on a second surface of the base board.

With the above mentioned arrangement, the chips mounted on each of opposite surfaces of the base board is heat-dissipated through the individual heat dissipating member, or heat generated in the chips mounted on each of opposite surfaces of the base board is blocked by the thermally insulating structure so as not to be transferred to the base board. Therefore, heat generated in each chip will never adversely influence to the other chips. Accordingly, without the problem occurring when the chips are mounted on opposite surfaces of the base board in the prior art, it is possible to increase the integration density of the multi-chip module.

The above and other objects, features and advantages of the present invention will be apparent from the following description of preferred embodiments of the invention with reference to the accompanying drawings.

### Brief Description of the Drawings

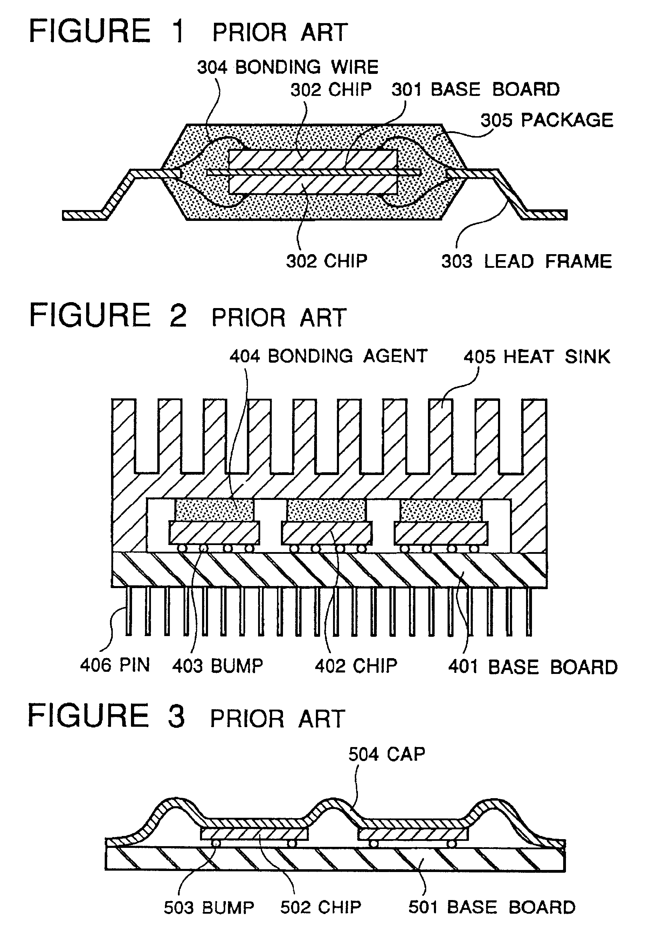

Figure 1 is a diagrammatic sectional view of one example of the conventional multi-chip module semiconductor device;
Figure 2 is a diagrammatic sectional view of an improved example of the conventional multi-chip module semiconductor device;
Figure 3 is a diagrammatic sectional view of another improved example of the conventional multi-chip module semiconductor device;
Figure 4 is a sectional view of a first embodiment of the multi-chip module semiconductor device in accordance with the present invention;
Figures 5A to 5D are sectional views illustrating a process for manufacturing the first embodiment of the multi-chip module semiconductor device in accordance with the present invention;
Figure 6 is a sectional view illustrating the first embodiment of the multi-chip module semiconductor device mounted on a printed board;
Figure 7 is a sectional view of a second embodiment of the multi-chip module semiconductor device in accordance with the present invention; and
Figures 8A and 8B are a bottom view and a front view of the chip mounted in the second embodiment of the multi-chip module semiconductor device in accordance with the present invention.

### Description of the Preferred embodiments

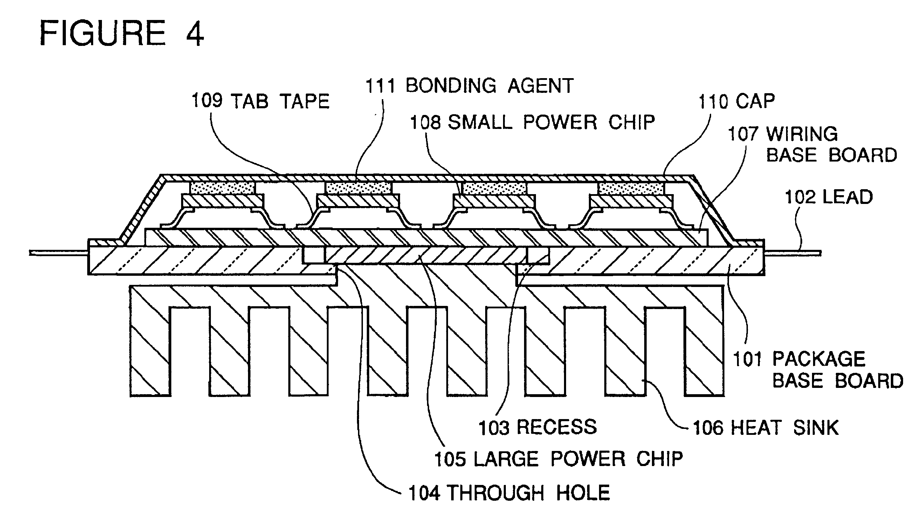

Referring to Figure 4, there is shown a sectional view of a first embodiment of the multi-chip module semiconductor device in accordance with the present invention.

A package base board 101 is formed of ceramics, for example, and has a plurality of leads 102 outward projecting from a periphery of the base board 101. Tile base board 101 also includes a plurality of wirings (not shown) which are electrically connected to the leads 102 and which are exposed at a plurality of predetermined portions (not shown) in an upper surface of the package base board 101.

Furthermore, a recess 103 is formed at a portion of the upper surface of the package base board 101, for example, at a center region of the upper surface of the package base board 101, and a through hole 104 is formed within the recess 103 to pass through the package base board 101. A large power semiconductor device chip 105 having a large consumed electric power is mounted within the recess 103. A heat sink 106 is fixed on a lower surface side of the package base board 101, in such a manner that the heat sink 106 is in direct contact with a lower surface of the large power chip 105 in the through hole 104.

In addition, a wiring base board 107 having a multi-layer wiring structure is put on the package base board 101 assembled with the large power chip 105 as mentioned above, and the wiring base board 107 is fixed to the package base board 101 in such a manner that electrodes (not shown) exposed at a lower surface of the wiring base board 107 are electrically connected by use of an electrically conductive bonding agent (not shown) to the wirings (not shown) exposed at the upper surface of the package base board 101.

On an upper surface of the wiring base board 107, a plurality of semiconductor device chips 108 having a small consumed electric power are mounted. In the shown embodiment, in order to mount the small power chips 108 on the wiring base board 107, a so called TAB tape is used. Thus, the small power chips 108 are mechanically and electrically connected onto the wiring base board 107 by a TAB tape 109.

Furthermore, a cap 110 is mounted to cover the wiring base board 107 and the small power chips 108 in such a manner that a periphery of the cap 110 is bonded to the upper surface of the package base board 101 by a bonding agent (not shown) so that the wiring base board 107 and the small power chips 108 are encapsulated by the cap 110 and the package base board 101. In this embodiment, the small power chips 108 are bonded to an internal surface of the cap 110 by means of a bonding agent 111 having a high thermal conductivity.

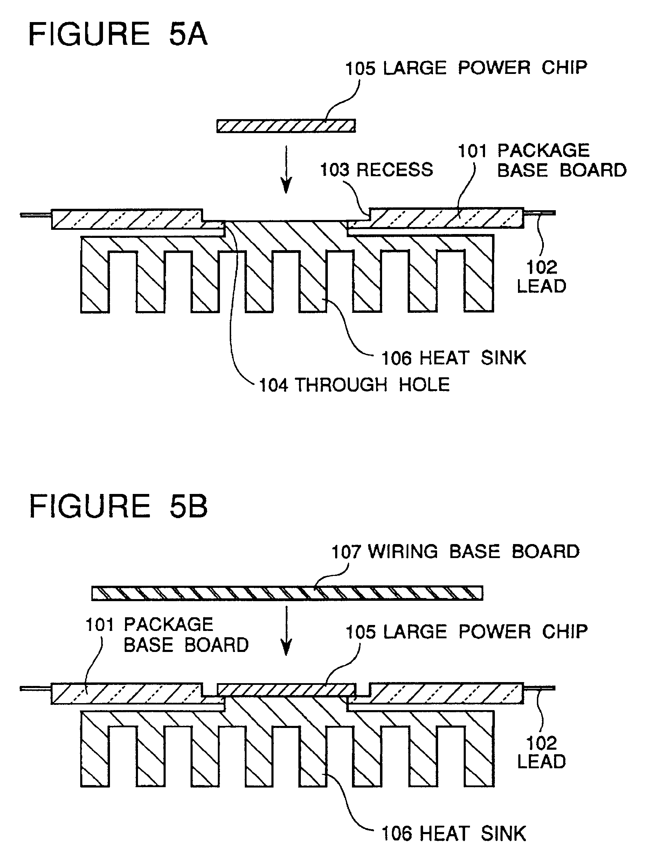

A process for manufacturing the multi-chip module semiconductor device shown in Figure 4 will be described with reference to Figures 5A to 5D.

As shown in Figure 5A, the heat sink 106 is mounted to the package base board 101 which has the recess 103 and the through hole 104 formed at the center region thereof and the leads 102 projecting from the periphery thereof. Then, the large power chip 105 is mounted on the heat sink 106 exposed within the recess 103 by a bonding agent (not shown) having a high thermal conductivity.

Thereafter, as shown in Figure 5B, the wiring base board 107 is put on the package base board 101, and the wiring base board 107 is fixed to die package base board 101 by such a manner that the electrodes (not shown) exposed at the lower surface of the wiring base board 107 are electrically connected by the electrically conductive bonding agent (not shown) to the wirings (not shown) exposed at the upper surface of the package base board 101. As mentioned hereinbefore, the wiring base board 107 is previously formed of the multi-layer wiring structure board, but can be formed by sequentially stacking a plurality of thin film wiring circuits.

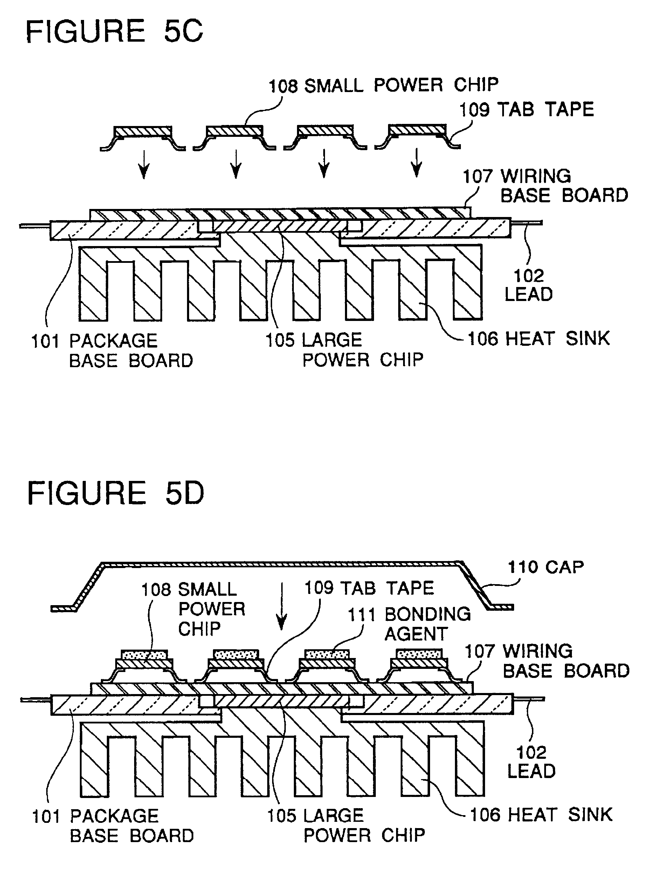

As shown in Figure 5C, a plurality of small power chips 108 connected to the TAB tape 109 are connected onto the wiring base board 107. Then, as shown in Figure 5D, a bonding agent 111 having a high thermal conductivity is put on each of the small power chips 108, and the cap 110 is mounted on the package base board 101 so as to cover the wiring base board 107 and the small power chips 108. At this time, the small power chips 108 are bonded and thermally coupled to the cap 110 by means of the bonding agent 111.

In the above mention structure, heat generated by the large power chip 105 is dissipated through the heat sink 106. In this case, a portion of the heat is transferred towards the wiring base board 107, but since almost all of the heat is dissipated through the heat sink 106, the heat transferred to the wiring base board 107 is very small.

On the other hand, heat generated by the plurality of small power chips 108 is transferred through the bonding agent 111 of the high thermal conductivity to the cap 110 and dissipated from the surface of the cap 110. Since these small power chips 108 are mounted on the wiring base board 107 by the TAB tape 109, the chips 108 are not in direct contact with the wiring base board 107, and therefore, only an extremely small portion of the heat generated by each chip 108 is transferred to the wiring base board 107.

Thus, the heat generated by the large power chip 105 scarcely influence the small power chips 108, and the heat generated by the small power chips 108 scarcely influence the large power ship 105. Accordingly, it is no longer necessary to make large the heat sink 106 for the large power chip 105, and therefore, it is possible to scale down the multi-chip module and to increase the integration density of the multi-chip module.

Incidentally, the bonding agent 111 on the small power chips 108 may be omitted, and the upper surface of the chips 108 can be resiliently contacted with the inner surface of the cap 110 by means of a resilient force of the TAB tapes 109, so that the heat of the chips 108 is directly transferred to the cap 110. In this case, since the bonding agent 111 is not intervened, a thermal resistance from the chips 108 to the cap 110 is reduced, and therefore, the heat dissipating effect can be elevated.

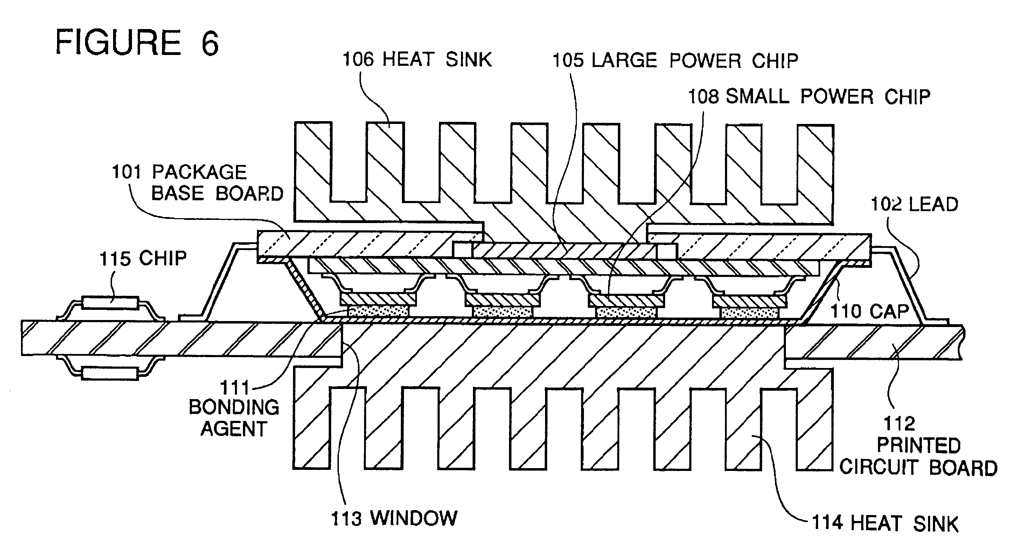

Referring to Figure 6, there is shown a sectional view illustrating the multi-chip module shown in Figure 4 mounted on a printed board.

The leads 102 of the package base board 101 are electrically connected to a printed circuit board 112. In the shown example, at this time, the cap 110 of the multi-chip module is directed toward the printed circuit board 112 in alignment with a window 113 formed through the printed circuit board 112. In addition, a heat sink 114 is thermally coupled to the cap 110 through the window 113. With this arrangement, the heat dissipating effect through the cap 110 is enhanced by the heat sink 114. Incidentally, a discrete chip 115 are mounted on each of opposite surfaces of the printed circuit board 112.

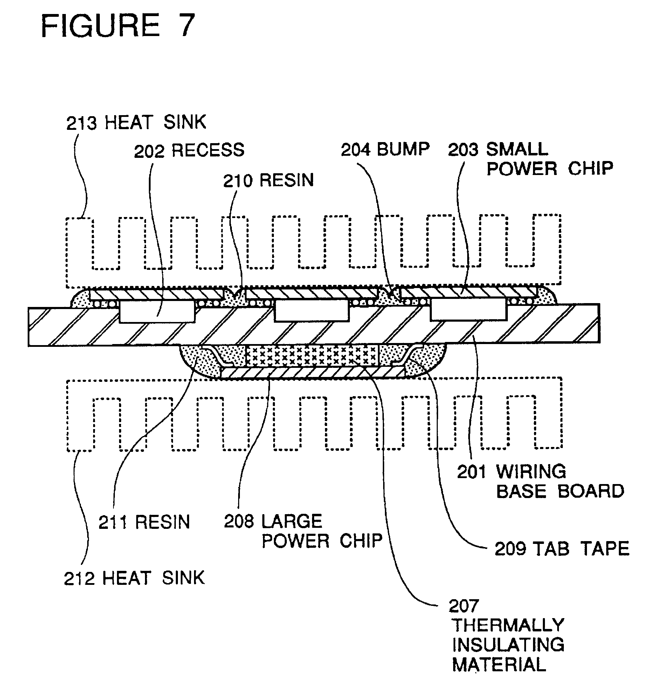

Referring to Figure 7, there is shown a sectional view of a second embodiment of the multi-chip module semiconductor device in accordance with the present invention.

A wiring base board 201 has a plurality of recesses 202 formed on an upper surface thereof separated from each other, and a plurality of small power chips 203 mounted on the upper surface of the board 201 in such a manner that each of the chips 203 is positioned to stride over a corresponding recess 202 and is mechanically and electrically connected to the wiring base board 201 by a flip-chip method which uses bumps 204.

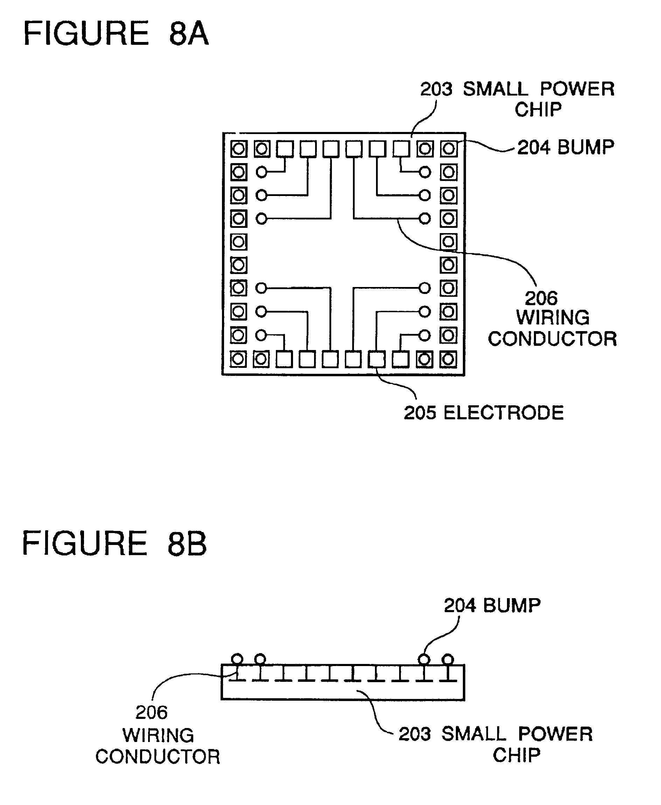

In this embodiments, as shown in a bottom view and a front view of Figures 8A and 8B, each chip 203 has a number of electrodes 205 along four side edges of the chip, but the bumps 204 are located along only two side edges opposite to each other, in two arrays in the shown embodiment. Accordingly, the bumps in an outer side array are connected directly to the electrodes positioned thereunder, and the bumps in an inner side array, excluding opposite end bumps of the bump array, are connected through a wiring conductor 206 to a corresponding electrode of the electrodes arranged along each of the remaining two side edges. Therefore, when the chip is mounted on the wiring base board 201, a gap is formed between the wiring base board 201 and the lower surface of the chip 203 at two side edge regions on which the bumps are not located, so that each recess 202 communicates with an external space through this gap.

On a rear surface of the wiring base board 201, a large power chip 208 is mounted by a thermally insulating material 207, and is mechanically and electrically connected to the wiring base board 201 by use of a TAB tape 209.

A resin 210 is injected to cover only a periphery of each small power chip 203 where the bumps 204 are provided, and a resin 211 is also injected to cover the TAB tape 209 of the large power chip 208.

Similarly to the first embodiment, but although not shown in Figure 7, a heat sink and a cap are contacted to the large power chip 208 and the small power chips 203, respectively. However, as shown in dotted lines in Figure 7, a heat sink 212 and a heat sink 213 can be contacted to the large power chip 208 and the small power chips 203, respectively.

In the second embodiment, therefore, heat generated by the large power chip 208 are dissipated through the heat sink 212 in contact with the large power chip 208, but since the heat generated by the large power chip 208 is blocked by the thermally insulating material 208 intervened, the heat generated by the large power chip 208 is not transferred to the small power chips 203. Therefore, this heat will not give any influence on the small power chips 203.

On the other hand, heat generated by the small power chips 203 are dissipated through the cap (not shown) or the heat sink 213 in contact with the small power chips 203. Since a space formed between the recess 202 of the wiring base board 201 and the lower surface of the small power chip 203, functions as a thermally insulating air layer, the transfer of the heat generated by the small power chips 203 towards the wiring base board 201 is effectively suppressed by the thermally insulating air layer. In this connection, since the recess 202 communicates with an external space through the gap formed between the wiring base board 201 and the lower surface of the chip 203 at two side edge regions on which the bumps are not located, the heat dissipating effect is enhanced by a flow of air through the gap.

In this embodiment, the thermally insulating material 207 provided for the large power chip 208 can be replaced by a space similar to the space formed in the recess 202 for the small power chip 203, and also, the space formed in the recess 202 for the small power chip 203 can be replaced with a thermally insulating material 207 similar to the thermally insulating material 207 provided for the large power chip 208. In addition, even if the heat sink and the cap are not provided, if a sufficient heat dissipating effect can be obtained, it is not necessary to provide the heat sink or the cap. In this connection, a mutual influence of the heat generated by the chips can be prevented by the thermally insulating structure formed between each surface of the wiring base board and the corresponding chips, and therefore, the integrated density of the multi-chip module can be elevated.

As seen from the above, according to one aspect of the present invention, since an individual heat dissipating member is provided for the chip or chips provided on each of opposite surfaces of the base board, the chip(s) mounted on each one surface of the base board is heat-dissipated through the associated individual heat dissipating member, independent of the heat dissipating member provided for the chip(s) mounted on the other surface of the base board. Therefore, heat generated in the chip(s) mounted on each one surface of the base board will never adversely influence to the chip(s) mounted on the other surface of the base board. Accordingly, it is possible to overcome the problem occurring when the chips are mounted on opposite surfaces of the base board in the prior art, and also it is possible to increase the integration density of the multi-chip module.

According to another aspect of the present invention, since the thermally insulating structure is intervened between each of opposite surfaces of the base board and the chip(s) mounted on the same surface of the base board, heat generated in each chip is prevented from being transferred to the base board. Therefore, heat generated in each chip will never adversely influence to the other chips. Accordingly, it is possible to overcome the problem occurring when the chips are mounted on opposite surfaces of the base board in the prior art, and also it is possible to increase the integration density of the multi-chip module.

According to still another aspect of the present invention, since an individual heat dissipating member is provided for the chip or chips provided on each of opposite surfaces of the base board, and since the thermally insulating structure is intervened between each of opposite surfaces of the base board and the chip(s) mounted on the same surface of the base board, heat generated in the chip(s) mounted on each one surface of the base board is dissipated through the associated individual heat dissipating member, independent of the heat dissipating member provided for the chip(s) mounted on the other surface of the base board, and simultaneously is prevented from being transferred to the base board by action of the thermally insulating structure. Therefore, heat generated in each chip will never adversely influence to the other chips. Accordingly, it is possible to overcome the problem occurring when the chips are mounted on opposite surfaces of the base board in the prior art, and also it is possible to increase the integration density of the multi-chip module.

The invention has thus been shown and described with reference to the specific embodiments. However, it should be noted that the present invention is in no way limited to the details of the illustrated structures but changes and modifications may be made within the scope of the appended claims.

## Claims

1. A multi-chip module semiconductor device comprising a base board, at least one first semiconductor device chip mounted on a first surface of said base board, at least one second semiconductor device chip mounted on a second surface of said base board, a first heat dissipating member provided for only said at least one first semiconductor device chip, and a second heat dissipating member provided for only said at least one second semiconductor device chip, independently of said first heat dissipating member.

2. A multi-chip module semiconductor device claimed in Claim 1 wherein said at least one first semiconductor device chip is mounted through a first thermally insulating structure on said first surface of said base board, and said at least one second semiconductor device chip is mounted through a second thermally insulating structure on said second surface of said base board.

3. A multi-chip module semiconductor device claimed in Claim 2 wherein said first thermally insulating structure is formed of a thermally insulating material, and said second thermally insulating structure is formed of a thermally insulating air layer formed between each second semiconductor device chip and said base board.

4. A multi-chip module semiconductor device comprising a base board, at least one first semiconductor device chip mounted through a first thermally insulating structure on a first surface of said base board, and at least one second semiconductor device chip mounted through a second thermally insulating structure on a second surface of said base board.

5. A multi-chip module semiconductor device claimed in Claim 4 wherein said first thermally insulating structure is formed of a thermally insulating material, and said second thermally insulating structure is formed of a thermally insulating air layer formed between each second semiconductor device chip and said base board.

6. A multi-chip module semiconductor device claimed in Claim 5 further including a first heat dissipating member provided for only said at least one first semiconductor device chip, and a second heat dissipating member provided for only said at least one second semiconductor device chip, independently of said first heat dissipating member.
